# EUROPEAN PATENT APPLICATION

(11) **EP 1 237 190 A2**
(43) Date of publication of application: **04.09.2002**
(21) Application number: 01306968.7
(22) Date of filing: 16.08.2001
(51) Int. Cl.: H01L 27/06, H01L 21/8252

(54) **Monolithic microwave integrated circuit and method for manufacturing the same**

(30) Priority: 03.03.2001 KR 2001011012
(71) Applicant: SAMSUNG ELECTRONICS CO., LTD., Suwon-City, Kyungki-do (KR)
(72) Inventor: Shim, Dong-sik, Seoul (KR); Lee, Sang-goog, Incheon Metropolitan-City (KR)
(74) Representative: Robinson, Ian Michael

(57) **Abstract**

A monolithic microwave integrated circuit (MMIC) and a method for manufacturing the same are provided. The MMIC includes active and passive devices 42 formed on a semiconductor substrate (40). A dielectric layer 46 is formed to cover the active and passive devices 42 on the semiconductor substrate; and a ground plane 48 is formed on the dielectric layer, for grounding the active device 42 through the dielectric layer 46.

## Description

The present invention relates to a monolithic microwave integrated circuit (MMIC) and a method for manufacturing the same, and more particularly, to an MMIC with a novel ground plane and a method for manufacturing the same.

Monolithic microwave integrated circuits (MMICs), which include active and passive devices formed in a single substrate by batch processing, are used to amplify small amplitude of signals and change frequencies. MMIC manufacturing techniques are considered to be paramount to increasing the yield of microwave systems by reducing the number of constituent parts as well as enabling the production of small, light-weighted systems.

For an MMIC, interconnects between unit devices as well as the active and passive devices in a semiconductor substrate are made by batch processing and thus the size of an MMIC board is smaller than a conventional high-frequency circuit board with high reliability and consistent characteristics. Also, a separate package of individual parts is not required, so manufacturing cost can be lowered compared to the manufacture of a conventional high-frequency circuit using a separate package for each part.

Unlike general microwave circuits, which must be made from parts which are available in a limited number of device packages, the shape and size of a device for an MMIC can be controlled by a designer and thus an optimal-performance MMIC can be manufactured for a specific use. The manufacturing cost of MMICs is unaffected by an increase in the number of active devices and thus there is an advantage of diversifying the circuit configuration.

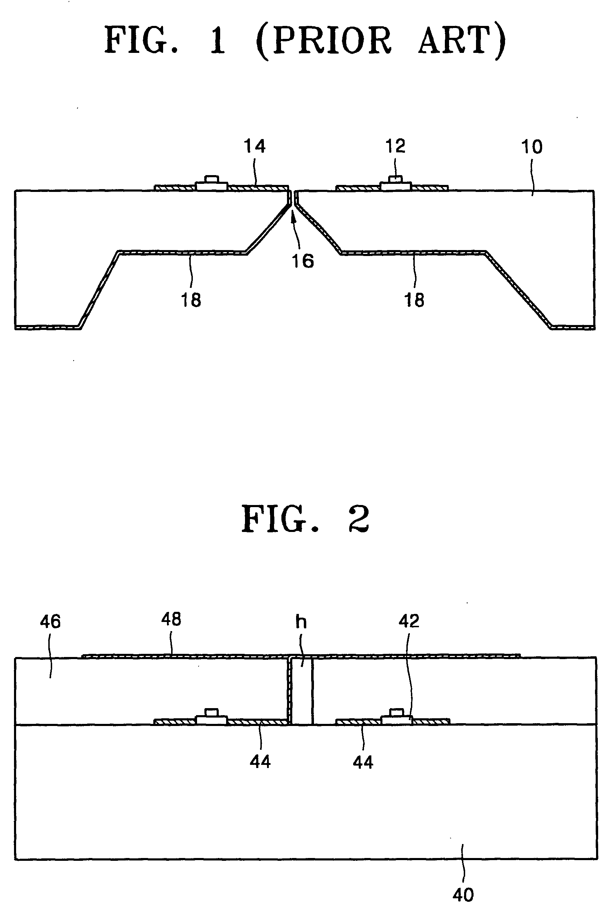

A conventional MMIC is shown in Figure 1. A semiconductor substrate 10 is formed to be thin enough to prevent coupling of signals between transmission modes at ultra high frequencies of tens of Gigahertzs. Reference numeral 12 represents an active device formed in the semiconductor substrate and reference numeral 14 represents a microstrip line for interconnecting the active device 12 and a passive device (not shown) in the semiconductor substrate 10. An opening 16 is formed in the semiconductor substrate 10 and a ground plane 18 is formed beneath the semiconductor substrate 10 such that it contacts the microstrip line 14 through the opening 16.

As described above, for conventional MMICs, the substrate 10 is formed to be thin to prevent coupling of signals between transmission modes. For example, it is preferable that the semiconductor substrate 10 has a thickness of 100 Φm or less at ultra high frequencies of tens of Gigahertzs. To obtain a semiconductor substrate 10 as thin as 100 Φm or less, formation of the active and passive devices in the semiconductor substrate 10 should be followed by etching or polishing of the back of the semiconductor substrate 10. However, thickness adjustment is difficult and such a thin semiconductor substrate of tens of micrometers is easily broken. Thus, the semiconductor substrate must be carefully handled so as not to reduce yield. In addition, dielectric loss caused by the dielectric constant of the semiconductor substrate is large, thereby increasing signal loss.

It is an aim of the present invention to provide a monolithic microwave integrated circuit (MMIC) capable of reducing signal loss caused by dielectric loss whilst preferably avoiding a drop in yield.

A second aim of the present invention to provide a simple method for manufacturing an MMIC that avoids, or at least reduces, the need for etching or polishing of the back of a semiconductor substrate. In particular, it is desired to avoid etching or polishing which is required, in the prior art, for preventing coupling of signals between transmission modes after formation of the active and passive devices of the MMIC.

According to a first aspect of the present invention there is provided an MMIC comprising: a semiconductor substrate; active and passive devices formed on the semiconductor substrate; a dielectric layer formed to cover the active and passive devices on the semiconductor substrate; and a ground plane formed on the dielectric layer, for grounding the active device through the dielectric layer.

It is preferable that the ground plane grounds the active device through a contact hole formed in the dielectric layer.

Also according to the present invention there is provided a method for manufacturing an MMIC, comprising: (a) forming active and passive devices on a semiconductor substrate such that the active and passive devices are interconnected; (b) forming a dielectric layer to cover the active and passive devices on the semiconductor substrate; and (c) forming a ground plane on the dielectric layer for grounding the active device.

In the MMIC manufacturing method, it is preferable that the active and passive devices are interconnected by a microstrip line. It is preferable that step (c) comprises: forming a contact hole, through which the microstrip line is exposed, in the dielectric layer; and forming the ground plane connected to the microstrip line through the contact hole by forming a conductive layer on the dielectric layer in which the contact hole is formed. The dielectric layer may be formed of a polymer layer.

Advantageously, MMICs having reduced signal loss caused by dielectric loss can be manufactured through a simplified process with high yield.

For a better understanding of the invention, and to show how embodiments of the same may be carried into effect, reference will now be made, by way of example, to the accompanying diagrammatic drawings in which:
Figure 1 is a sectional view of a conventional monolithic microwave integrated circuit (MMIC);
Figure 2 is a sectional view of a preferred embodiment of a MMIC according to the present invention; and
Figures 3 through 6 are sectional views illustrating each step of a method for manufacturing the MMIC of Figure 2.

Preferred embodiments of a monolithic microwave integrated circuit (MMIC) and a method for manufacturing the same according to the present invention will be described with reference to the appended drawings. In the drawings, the thickness of layers and regions are exaggerated for clarity.

A preferred embodiment of an MMIC according to the present invention will be described with reference to Figure 2. Referring to Figure 2, a semiconductor substrate 40 may be formed of a silicon substrate, and preferably of a III-V compound semiconductor substrate, tacking account of an MMIC terminal that needs a small, light-weight, and low-power consumption RF device. For example, the semiconductor substrate 40 may be a GaAs substrate. Although not a III-V compound, a SiGe substrate can be used as the semiconductor substrate 40. An active device 42, for example, a high-frequency transistor, is formed on the semiconductor substrate 40. Although not illustrated, a passive device such as a capacitor or an inductor is formed on the semiconductor substrate 40. The active device 42 and passive device are interconnected on the semiconductor substrate 40. A dielectric layer 46 having a predetermined thickness is formed to cover all the devices and interconnect lines formed on the semiconductor substrate 40. Preferably, the dielectric layer 46 is formed of a polymer layer, for example, a polyimide or photoresist layer. A contact hole *h* through which a microstrip line 44 is exposed is formed in the dielectric layer 46 and a ground plane 48 is formed on the dielectric layer 46, wherein the ground plane 48 is connected to a portion of the microstrip line 44 exposed through the contact hole *h*. As shown in Figure 2, the ground plane 48 may extend along the sidewall of the contact hole *h* such that it contacts the microstrip line 44. Alternatively, the ground plane 48 may be connected to the microstrip line 44 by a conductive plug (not shown) filing the contact hole *h*.

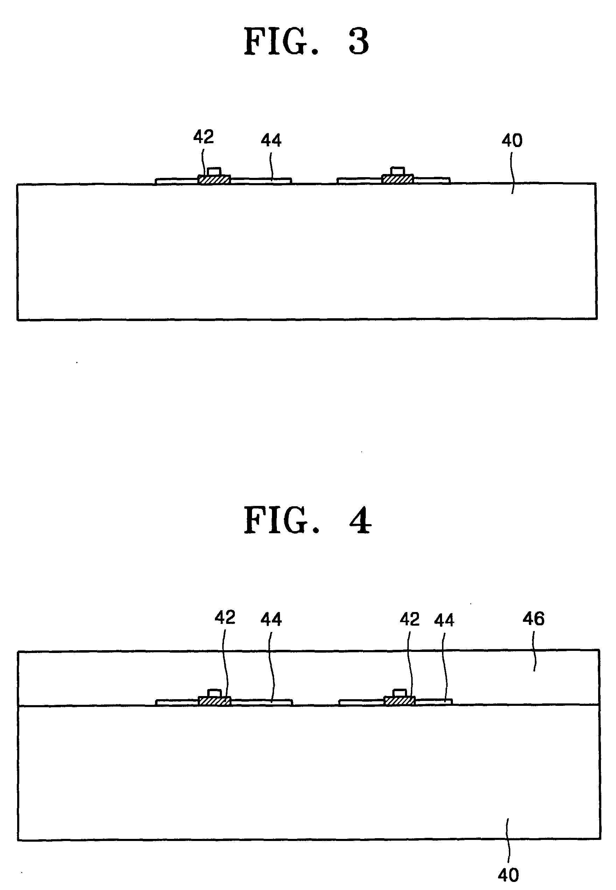

The MMIC according to the present invention is manufactured as follows. Referring to Figure 3, the active device 42 and passive device are formed on the semiconductor substrate 40 and the microstrip line 44 for interconnecting the active device 42 and passive device is formed. The semiconductor substrate 40 may be formed of a silicon substrate for a relatively low-frequency device, and preferably, of a III-V compound semiconductor substrate, for example, a GaAs substrate. Although not a III-V compound, a SiGe substrate can be used as the semiconductor substrate 40. The active device 42 is a transistor such as a high-frequency metal semiconductor field effect transistor (MESFET). This MESFET may be formed by performing selective implantation with Si ion, activating to form a channel region, etching to form a recess for appropriate characteristics, and forming a metal gate in the recess. As described above, the active device may be formed through a semiconductor device manufacturing process.

As an example of the passive device, a capacitor or inductor is formed on the semiconductor substrate 40.

Next, as shown in Figure 4, a dielectric layer 46 is formed to cover the active device 42, the microstrip line 44, and the passive device on the semiconductor substrate 40. It is preferable that the dielectric layer 46 is formed of a polymer layer, for example, a polyimide layer or photoresist layer. It is also preferable that the dielectric layer 46 is formed thick enough, taking into account subsequent polishing of the back of the semiconductor substrate 40. The thickness of the dielectric layer 46 is determined by considering the extent to which the semiconductor substrate 40 can be thinned by polishing or etching of the back of the semiconductor substrate 40 without breaking of the semiconductor substrate 40. After the formation of the dielectric layer is completed, the back of the semiconductor substrate 40 is polished to reduce the thickness and to prevent signals from coupling between transmission modes. As a result, the dielectric layer 46 can prevent signal loss caused by dielectric loss and breaking of the semiconductor substrate 40 after the semiconductor substrate 40 is thinned by polishing.

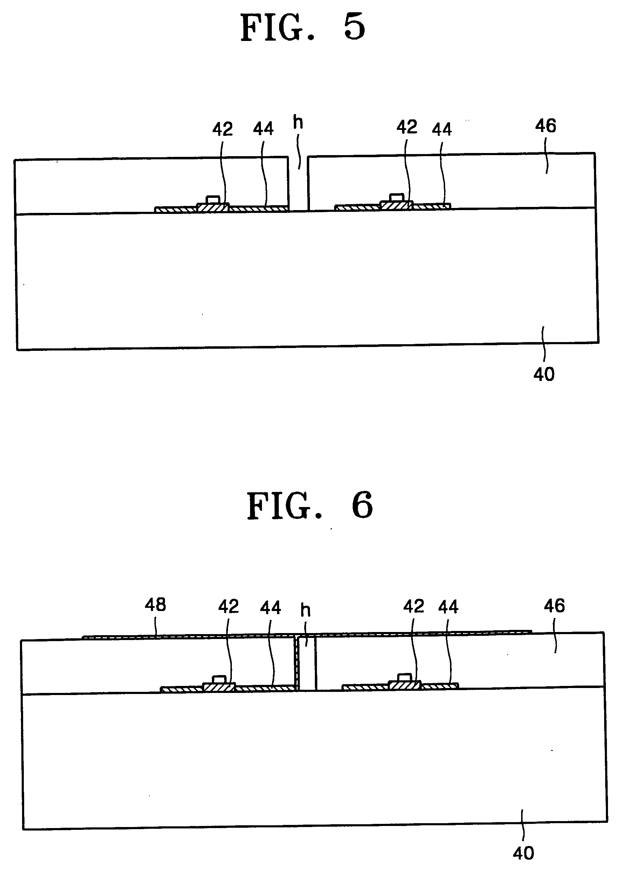

Next, as shown in Figure 5, a contact hole *h* through which the microstrip line 44 is exposed is formed in the dielectric layer 46. When the dielectric layer 46 is formed of a photosensitive material layer, such as a polyimide or photoresist layer, the contact hole *h* is formed by forming a mask (not shown) on the dielectric layer 46 to define a region to be the contact hole *h*, exposing using the mask, removing the mask, and developing the resultant structure.

Meanwhile, when the dielectric layer 46 is formed of a non-photosensitive material, a mask is formed on the dielectric layer 46 to define a region to be the contact hole *h*, the defined region of the dielectric layer 46 is etched using the mask, and the mask is removed, thereby forming a contact hole *h.*

The shape and size of the contact hole *h* is not limited as long as the microstrip line 44 can be exposed by the same. For example the microstrip line 44 may be exclusively exposed by the contact hole *h*, or both the semiconductor substrate 40 and microstrip line 44 may be partially exposed through the contact hole *h*.

Next, referring to Figure 6, a conductive layer is formed as the ground plane 48 on the dielectric layer 46 such that a portion of the ground plane 48 is coupled to the microstrip line 44 through the contact hole *h*. As shown in Figure 6, the ground plane 48 may extend along the sidewall of the contact hole *h* to reach a portion of the microstrip line 44 exposed through the contact hole *h*. Alternatively, the ground plane 48 may contact the exposed portion of the microstrip line 44 by, for example, a conductive plug filling the contact hole *h*.

As described above, in the MMIC according to the present invention, the ground plane connected to the microstrip line is formed on the dielectric layer formed to cover the active and passive devices on the semiconductor substrate. In other words, the ground plane is placed above devices to be grounded by the same. Thus, signal loss caused by dielectric loss can be reduced and the overall manufacturing process can be simplified because there is no need to perform polishing or etching of the back of the semiconductor substrate. Although the semiconductor substrate is processed to be thin enough for the purpose of preventing coupling of signals between transmission modes, due to the dielectric layer formed on the semiconductor substrate to have a thickness large enough to prevent the semiconductor substrate from breaking, yield does not drop.

While this invention has been particularly shown and described with reference to preferred embodiments thereof, it will be understood by those skilled in the art that various changes in form and details may be made therein. For example, it will be appreciated to those skilled in the art that the dielectric layer may be formed to incorporate air gaps or may be formed as multiple layers. In addition, the structure of the ground plane according to the present invention can be applied to other devices excluding MMIC.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extend to any novel one, or any novel combination, of the features disclosed in this specification (including any accompanying claims, abstract and drawings), or to any novel one, or any novel combination, of the steps of any method or process so disclosed.

## Claims

1. A monolithic microwave integrated circuit comprising:
a semiconductor substrate (40);
active and passive devices (42) formed on the semiconductor substrate (40);
a dielectric layer (46) formed to cover the active and passive devices on the semiconductor substrate; and
a ground plane (48) formed on the dielectric layer, for grounding the active device through the dielectric layer.

2. The monolithic microwave integrated circuit of claim 1, wherein the ground plane (48) grounds the active device through a contact hole (h) formed in the dielectric layer (46).

3. The monolithic microwave integrated circuit of claim 1, wherein the dielectric layer (46) is formed of a polymer layer.

4. The monolithic microwave integrated circuit of claim 3, wherein the polymer layer is a polyimide layer or a photoresist layer.

5. A method for manufacturing a monolithic microwave integrated circuit, comprising:
(a) forming active and passive devices (42) on a semiconductor substrate (40) such that the active and passive devices are interconnected;
(b) forming a dielectric layer (46) to cover the active and passive devices on the semiconductor substrate; and
(c) forming a ground plane (48) on the dielectric layer for grounding the active device.

6. The method of claim 5, wherein the active and passive devices are interconnected by a microstrip line (44).

7. The method of claim 6, wherein step (c) comprises:
forming a contact hole (h), through which the microstrip line (44) is exposed, in the dielectric layer; and
forming the ground plane (48) connected to the microstrip line through the contact hole by forming a conductive layer on the dielectric layer in which the contact hole is formed.

8. The method of claim 5, wherein the dielectric layer (46) is formed of a polymer layer.

9. The method of claim 5 or 6, wherein the active device is a high-frequency transistor.
